Europäisches Patentamt

European Patent Office

Office européen des brevets

(11) Numéro de publication: **0 095 963**
**A1**

(12) **DEMANDE DE BREVET EUROPEEN**

(21) Numéro de dépôt: **83400997.9**

(22) Date de dépôt: **19.05.83**

(51) Int. Cl.³: **C 23 C 11/00**

(30) Priorité: **19.05.82 FR 8208764**

(43) Date de publication de la demande: **07.12.83**
**Bulletin 83/49**

(84) Etats contractants désignés: **AT BE CH DE FR GB IT LI LU NL SE**

(71) Demandeur: **CREUSOT-LOIRE, 42 rue d'Anjou, F-75008 Paris (FR)**

(72) Inventeur: **Swat, Christian, 7 rue du Champ de Mars, F-42700 Firminy (FR)**
Inventeur: **Leveque, Robert, 40 rue du Champ de Mars, F-42700 Firminy (FR)**

(74) Mandataire: **Leroy, Pierre et al, CREUSOT-LOIRE 15 rue Pasquier, F-75383 Paris Cedex 08 (FR)**

(54) **Procédé de revêtement en phase gazeuse de petits orifices ménagés dans des pièces en acier.**

(57) L'invention concerne le revêtement d'orifices de diamètre au plus égal à 20 mm, ménagés dans des pièces en acier.

A cet effet, l'invention a pour objet un procédé chimique de revêtement en phase gazeuse, à base d'au moins un élément d'apport de degré d'électropositivité plus élevé que celui du fer, de la surface d'orifices de diamètre constant ou variable sur leur longueur, au plus égal à 20 mm, ménagés dans des pièces en aciers, ce procédé utilisant une atmosphère réductrice ou neutre, comprenant au moins de l'hydrogène et des vapeurs halogénées, avec ou sans argon, à des températures comprises entre 800 et 1050°C, et étant caractérisé en ce que ledit élément d'apport constitue tout ou partie d'au moins un noyau cylindrique obtenu préalablement par frittage, imprégné en surface d'un halogénure d'ammonium, et disposé au centre de l'orifice à revêtir, sur toute sa longueur, d'une manière bien centrée, ce noyau cylindrique ayant un diamètre inférieur à celui de l'orifice à revêtir.

L'invention s'applique spécialement bien à la chromisation de petits orifices de pièces en aciers.

## Procédé de revêtement en phase gazeuse de petits orifices ménagés dans des pièces en aciers

La présente invention concerne le revêtement en phase gazeuse de la surface interne de petits orifices, de diamètre constant ou variable sur leur longueur, au plus égal à 20 millimètres, et de longueur pouvant aller jusqu'à deux mètres, ménagés dans des pièces en aciers, le revêtement étant à base d'au moins un élément d'apport de degré d'électropositivité plus élevé que celui du fer, tel que le chrome, l'aluminium, le titane, le tantale, le zirconium, le niobium, le vanadium, le silicium.

La technique de dépôt métallique par voie chimique en phase gazeuse selon les procédés de L'ONERA (Office National d'Etudes et de Recherches Aéronautiques) est maintenant bien connue. L'obtention de la vapeur métallique est réalisée par action d'un halogénure, par exemple le chlorure ou le fluorure d'ammonium, sur un cément pulvérulent constitué par l'élément à déposer, par exemple du chrome ou du ferro-chrome lorsqu'il s'agit d'une chromisation, du ferro-aluminium lorsqu'il s'agit d'une calorisation, du ferro-titane lorsqu'il s'agit d'une titanisation, du ferro-silicium lorsqu'il s'agit d'une siliciuration. Cette vapeur métallique constituée par un halogénure de l'élément d'apport est obtenue dans une caisse de cémentation à des températures comprises entre 800 et 1100°C, selon la nature du revêtement à réaliser.

L'intérêt de ce procédé réside dans l'obtention d'une vapeur métallique homogène et à la condition que le cément pulvérulent soit en contact ou à une distance donnée, mais relativement constante des pièces à revêtir. Cette technique est en particulier utilisée couramment pour effectuer des dépôts à l'intérieur d'alésages de diamètre supérieur ou égal à 20 mm. Dans ces conditions, le cément est disposé à l'intérieur des pièces à traiter avec, à chaque extrémité, un bouchon poreux en matière réfractaire assurant un passage suffisant de gaz porteur (argon ou hydrogène) pour obtenir un revêtement homogène d'une extrémité à l'autre de l'alésage.

Pour empêcher l'autofrittage de ce cément en présence d'halogénures gazeux, on utilise soit un diluant à base d'alumine, ou éventuellement de silice, dans le cas où ce cément est pulvérulent (les proportions de diluant varient alors entre 30 et 50 %), soit un cément de forte granulométrie sans diluant (la dimension moyenne des grains pouvant être comprise entre 1 et 3 mm).

Toutefois, l'utilisation de l'une ou l'autre de ces technologies ne permet pas d'effectuer un revêtement correct à l'intérieur d'alésages de diamètre inférieur à 20 mm. En effet, dans ce cas, il y a, soit frittage du cément dans les conditions habituelles d'obtention de ce dernier, soit forte hétérogénéité dans l'épaisseur du revêtement si l'on choisit des grains de cément trop grossiers en raison de la mauvaise répartition des halogénures destinés à fournir la vapeur métallique.

Le but de la présente invention est donc de pouvoir réaliser, à partir d'une technique dérivée des procédés de l'ONERA mentionnés ci-dessus, des revêtements homogènes et de bonnes propriétés à l'intérieur d'orifices de diamètre inférieur ou égal à 20 mm, que les techniques connues ne permettent pas d'obtenir, de façon satisfaisante.

Dans la présente invention, la phase vapeur est réalisée à haute température par réaction entre l'élément d'apport obtenu préalablement sous forme de noyaux cylindriques et un halogénure d'ammonium, par exemple le chlorure ou le fluorure, disposé à la surface du ou des noyaux cylindriques.

Les noyaux cylindriques sont réalisés préalablement par autofrittage de grains pulvérulents de granulométrie inférieure à 400 micromètres sous atmosphère d'halogénure grâce à l'addition de 0,5 à 1,5 % en poids d'halogénure d'ammonium, à une température comprise entre 800 et 1000°C et pendant une durée n'excédant pas 20 heures. La vapeur métallique créée facilite la formation de ponts d'adhésion entre les particules par phénomène de transport. L'autofrittage des grains de cément est réalisé dans des tubes en éléments réfractaires, en alumine par exemple. Cette opération est suivie par un refroidissement lent des produits à la température ambiante.

Les noyaux cylindriques de l'élément d'apport ainsi obtenus préalablement par autofrittage ont une porosité ouverte importante, supérieure à 10 % en volume, et cette porosité est utilisée pour retenir les grains d'halogénure qui vont être nécessaires pour assurer ensuite l'émission de vapeur métallique à haute température dans la caisse de cémentation.

En effet, ces noyaux cylindriques de l'élément d'apport sont ensuite disposés au centre de chacun des petits orifices à revêtir et la pièce en acier dans laquelle sont disposés ces petits orifices à revêtir est placée dans une caisse de cémentation et portée à une température comprise entre 800°et 1050°C. Un balayage à l'hydrogène, avec ou sans argon, est pratiqué pendant l'opération.

Sur toute la longueur de chacun des noyaux et de chacun des orifices, l'halogénure d'ammonium réagit avec l'élément d'apport pour produire un halogénure de l'élément d'apport à l'état gazeux, qui constitue la phase de transport dudit élément d'apport depuis le noyau central cylindrique jusqu'à la surface interne de chacun des orifices à revêtir. La distance radiale à réaliser entre chaque noyau et la surface interne de chaque orifice à traiter dépend essentiellement de la durée de vie de l'halogénure gazeux de transport à la température de traitement. Cette distance radiale est toujours comprise entre 1 et 6 Millimètres.

Ainsi, la présente invention a pour objet un procédé chimique de revêtement en phase gazeuse, à base d'au moins un élément d'apport de degré d'électropositivité plus élevé que celui du fer, de la surface d'orifices de diamètre constant ou variable sur leur longueur, au plus égal à 20 millimètres, ménagés dans des pièces en aciers, ce procédé utilisant une atmosphère réductrice ou neutre, comprenant au moins de l'hydrogène et des vapeurs halogénées, avec ou sans argon, à des températures comprises entre 800° et 1050°C, et étant caractérisé en ce que ledit élément d'apport constitue tout ou partie d'au moins un noyau cylindrique obtenu préalablement par frittage, imprégné en surface d'un halogénure d'ammonium, d'un diamètre inférieur à celui de l'orifice à revêtir, disposé au centre de cet orifice de manière que sa distance à la paroi de cet orifice soit constante sur tout le pourtour et sur toute la longueur dudit noyau central et comprise entre 1 et 6 millimètres, et en ce qu'une réaction intervenant entre l'élément d'apport présent dans le noyau cylindrique et l'halogénure d'ammonium superficiel dudit noyau, produit sous forme gazeuse un halogénure de l'élément d'apport, qui constitue une phase de transport dudit élément d'apport depuis le noyau central cylindrique jusqu'à la surface à revêtir.

Les éléments d'apport de degré d'électropositivité plus élevé que celui du fer, présents dans les noyaux centraux cylindriques, sont constitués par au moins l'un des corps simples suivants : chrome, aluminium, titane, tantale, zirconium, niobium, vanadium, silicium.

Suivant une caractéristique particulière de la présente invention, l'atmosphère réductrice ou neutre de la caisse de cémentation, en plus de l'hydrogène et des halogénures du ou des éléments d'apport, contient des hydrocarbures gazeux craqués, ou de l'ammoniac craqué et ou du gaz carbonique, et la composition chimique du noyau central est ajustée convenablement de façon à provoquer l'émission de vapeurs contenant le ou les éléments d'apport, de telle sorte que ces vapeurs, réagissant avec les constituants de la surface de la paroi des orifices à revêtir, provoquent sur celle-ci la formation de composés définis tels que des carbures, des oxydes, des nitrures, des carbonitrures, du ou des éléments d'apport.

Dans le cas particulier d'une chromisation gazeuse de la surface interne d'orifices d'au plus 20 millimètres de diamètre, l'invention est caractérisée en outre en ce que l'élément d'apport est constitué de ferrochrome de granulométrie inférieure à 400 micromètres, en ce que l'halogénure d'ammonium superficiel est du chlorure d'ammonium, et en ce que la distance entre le noyau central cylindrique et la surface de la paroi de l'orifice à revêtir est comprise entre 1 et 6 Millimètres.

Comme on le comprend, les avantages du procédé selon la présente invention qui vient d'être décrit, par rapport aux procédés connus qui ont été rappelés antérieurement, résident essentiellement dans :

1°- l'amélioration de l'état de surface du revêtement grâce à l'absence de soudure locale des grains de cément sur la paroi du substrat pouvant entrainer des phénomènes de corrosion.

2°- la possibilité d'extraction du cément après le traitement thermique de trempe et revenu qui suit l'opération du dépôt métallique.

3°- l'obtention de propriétés homogènes du revêtement d'une extrémité à l'autre de l'orifice revêtu.

Dans le procédé selon l'invention, le dépôt est obtenu au moyen d'un mélange d'une vapeur constituée par l'halogénure du matériau d'apport et d'une atmosphère réductrice ou neutre (argon ou hydrogène par exemple). Sans sortir du cadre de l'invention, on peut envisager des revêtements de carbures, oxydes ou nitrures du matériau d'apport par deux voies distinctes :
1°) l'utilisation d'atmosphères réactives contenant, en plus de l'argon ou de l'hydrogène, des proportions variables d'hydrocarbures ou d'ammoniac craqué ou de gaz carbonique.

2°) une mise en condition préalable du substrat à l'aide par exemple d'une cémentation ou d'une nitruration, ou éventuellement d'une oxydation, contrôlées.

Dans ces conditions, la vapeur contenant le ou les éléments d'apport réagit avec les constituants de la surface de la paroi des orifices à revêtir pour former sur cette dernière des composés définis tels que carbures, nitrures ou oxydes.

Afin de bien faire comprendre l'objet de l'invention, on va décrire ci-après, à titre d'exemple non limitatif, un mode de réalisation selon l'invention relatif à la chromisation de l'intérieur d'un orifice de 6,5 mm de diamètre et de 650 mm de longueur en acier allié du type 32 CDV 13. (à 0,32 % C et 3,25 % Cr, avec 1 % de Mo et 0,2 % de V).

Des noyaux cylindriques de diamètre 4 mm ont été obtenus par autofrittage de ferrochrome à 70 % Cr pulvérulent de granulométrie inférieure à 400 micromètres. Cet autofrittage a eu lieu par maintien de 10 heures à 950°C en mélangeant au ferrochrome 1% en poids de chlorure d'ammonium, sous une atmosphère porteuse d'hydrogène. La longueur des éléments cylindriques autofrittés était comprise entre 50 et 150 mm.

Ces éléments ainsi obtenus ont été empilés à l'intérieur de l'alésage de diamètre 6,5 mm sur fond poreux d'alumine après avoir été enduits de chlorure d'ammonium pulvérulent dont les grains ont occupé tout ou partie de la porosité ouverte.

L'équipage a été porté dans un four vertical à la température de 950°C pendant 15 heures sous atmosphère d'hydrogène et a subi après ce maintien un refroidissement suffisamment rapide pour permettre une trempe martensique de l'acier 32 CDV 13. Après revenu de l'ensemble à 650°C pendant 2 heures donnant au substrat les propriétés d'emploi requises, les résultats obtenus ont été les suivants :

- épaisseur de la couche chromisés comprise entre 12 et 19 micromètres avec deux types de carbures M7C3 et M23C6, ce qui est conforme aux résultats obtenus par chromisation de ce type d'acier.

- dureté de la couche en moyenne de 1700 HV 0,025 avec une dispersion maximale de ± 300 HV 0,025 (HV 0,025 : microdureté Vickers sous une charge de 25 grammes).

- bon accrochage de la couche de carbure de chrome sur le substrat grâce à une diffusion de l'élément chrome sur une profondeur de 15 micromètres entrainant une augmentation de la dureté de l'acier de 100 HV 0,1 (HV 0,1 : microdureté Vickers sous une charge de 100 grammes) immédiatement au-dessous de la couche (dureté à coeur du substrat métallique : 350 HV 0,1).

Il est bien entendu que l'on peut, sans sortir du cadre de l'invention, imaginer des variantes et perfectionnements de détails, de même qu'envisager l'emploi de moyens équivalents.

L'invention, qui s'applique à de nombreux types de revêtement d'orifices de petits diamètres ménagés dans des pièces en acier, s'applique spécialement bien à la chromisation de tels orifices.

REVENDICATIONS

1- Procédé chimique de revêtement en phase gazeuse, à base d'au moins un élément d'apport de degré d'électro-positivité plus élevé que celui du fer, de la surface d'orifices de diamètre constant ou variable sur leur longueur, au plus égal à 20 millimètres, ménagés dans des pièces en aciers, ce procédé utilisant une atmosphère réductrice ou neutre, comprenant au moins de l'hydrogène et des vapeurs halogénées, avec ou sans argon, à des températures comprises entre 800° et 1.050°C, et étant caractérisé en ce que ledit élément d'apport constitue tout ou partie d'au moins un noyau cylindrique obtenu préalablement par frittage, imprégné en surface d'un halogénure d'ammonium, d'un diamètre inférieur à celui de l'orifice à revêtir, disposé au centre de ce orifice de manière que sa distance à la paroi de cet orifice soit constante sur tout le pourtour et sur toute la longueur dudit noyau central et comprise entre 1 et 6 millimètres, et en ce qu'une réaction, intervenant entre l'élément d'apport présent dans le noyau central cylindrique et l'halogénure d'ammonium superficiel dudit noyau, produit sous forme gazeuse un halogénure de l'élément d'apport, qui constitue une phase de transport dudit élément d'apport depuis le noyau central cylindrique jusqu'à la surface à revêtir.

2- Procédé de revêtement selon la revendication 1, caractérisé en ce que l'élément d'apport de degré d'électropositivité plus élevé que celui du fer, présent dans le noyau central cylindrique, est constitué par au moins l'un des corps simples suivants : chrome - aluminium - titane - tantale - zirconium - niobium - vanadium - silicium.

3- Procédé de revêtement selon l'une quelconque des revendications 1 et 2, caractérisé en ce que l'atmosphère réductrice ou neutre, en plus de l'hydrogène et des halogénures du ou des éléments d'apport, contient des hydrocarbures gazeux craqués, ou de l'ammoniac craqué et ou du gaz carbonique, et en ce que la composition chimique du noyau central est ajustée convenablement de façon à provoquer l'émission de vapeurs contenant le ou les éléments d'apport, de telle sorte que ces vapeurs, réagissant avec les constituants de la surface de la paroi des orifices à revêtir, provoquent sur celle-ci la formation de composés définis tels que des carbures, des oxydes, des nitrures, des carbonitrures, du ou des éléments d'apport.

4- Procédé de revêtement selon l'une quelconque des revendications 1 à 3, consistant en une chromisation gazeuse de la paroi d'orifices d'au plus 20 millimètres de diamètre, caractérisé en ce que l'élément d'apport est constitué de ferro-chrome de granulométrie inférieure à 400 micromètres, en ce que l'halogènure d'ammonium superficiel est du chlorure d'ammonium, et en ce que la distance entre le noyau central cylindrique et la surface de la paroi de l'orifice à revêtir est comprise entre 1 et 6 millimètres.

Office européen
des brevets

Numéro de la demande

EP   83 40 0997

**RAPPORT DE RECHERCHE EUROPEENNE**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. 3) |
|---|---|---|---|
| Y | FR-A-1 126 055  (SIEMENS) <br> * Page 2, exemple 2 * | 1,2 | C 23 C   11/00 |
| Y | FR-A-1 216 207  (P. VULLIEZ) <br> * En entier * | 1 | |
| Y | FR-A-1 142 013  (P. VULLIEZ) <br> * Résumé; figure * | 1 | |
| Y | FR-E-   62 109  (O.N.E.R.A.) <br> * Résumé; page 2, colonne de droite, dernier paragraphe * | 3 | |
| Y | FR-A-1 321 211  (DEUTSCHE EDELSTAHLWERKE) <br> * Résumé * | 5 | **DOMAINES TECHNIQUES RECHERCHES (Int. Cl. 3)** |
| Y | US-A-2 811 466  (G.A. SAMUEL) <br> * Page 1, colonne 1, ligne 66 * | 5 | C 23 C    9/00 <br> C 23 C   11/00 |
| A | FR-A-2 205 583  (C.E.A.) <br> * Figure 1 * | 1 | |
| A | FR-A-2 057 003  (METALLWERK PLANSEE) <br> * Revendications 1,8 * | 3 | |
| A | US-A-3 783 007  (J.A. BLOOM) | | |

---        -/-

Le présent rapport de recherche a été établi pour toutes les revendications

| Lieu de la recherche <br> LA HAYE | Date d'achèvement de la recherche <br> 31-08-1983 | Examinateur <br> DEVISME F.R. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

Office européen
des brevets

**RAPPORT DE RECHERCHE EUROPEENNE**

Numéro de la demande

EP 83 40 0997

| | DOCUMENTS CONSIDERES COMME PERTINENTS | | Page 2 |
|---|---|---|---|
| Catégorie | Citation du document avec indication, en cas de besoin, des parties pertinentes | Revendication concernée | CLASSEMENT DE LA DEMANDE (Int. Cl. ³) |
| A | FR-A-1 162 535 (SOCIETE BELGE DE L'AZOTE)<br><br>----- | | |
| | | | DOMAINES TECHNIQUES RECHERCHES (Int. Cl. ³) |

Le présent rapport de recherche a été établi pour toutes les revendications

| Lieu de la recherche<br>LA HAYE | Date d'achèvement de la recherche<br>31-08-1983 | Examinateur<br>DEVISME F.R. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

                                                     
& : membre de la même famille, document correspondant